(19) 

Europäisches
Patentamt

European
Patent Office

Office européen
des brevets

(11) **EP 4 604 444 A1**

(12) **DEMANDE DE BREVET EUROPEEN**

(43) Date de publication:
   **20.08.2025 Bulletin 2025/34**

(21) Numéro de dépôt: **25155945.6**

(22) Date de dépôt: **05.02.2025**

(51) Classification Internationale des Brevets (IPC):
   ***H04L 7/033*** (2006.01)      ***G06F 1/04*** (2006.01)
   ***G11C 7/22*** (2006.01)

(52) Classification Coopérative des Brevets (CPC):
   **G06F 1/04; G11C 7/222; H03K 5/135**

(84) Etats contractants désignés:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Etats d'extension désignés:
   **BA**
   Etats de validation désignés:
   **GE KH MA MD TN**

(30) Priorité: **12.02.2024 FR 2401337**

(71) Demandeur: **STMicroelectronics International
   N.V.
   1228 Plan-les-Ouates, Geneva (CH)**

(72) Inventeurs:
   • **ABOUZEID, Fady
     38660 LA TERRASSE (FR)**
   • **ROUGET, Antoine
     38000 GRENOBLE (FR)**
   • **EVANS, Adrian
     38054 GRENOBLE CEDEX 09 (FR)**
   • **MENGUE, Vincent
     38054 GRENOBLE CEDEX 09 (FR)**

(74) Mandataire: **Cabinet Beaumont
   4, Place Robert Schuman
   B.P. 1529
   38025 Grenoble Cedex 1 (FR)**

(54) **GENERATION D'UN SIGNAL D'HORLOGE**

(57)      La présente description concerne un procédé de génération d'un premier signal d'horloge (S_Clk) à partir d'un deuxième signal d'horloge (Clk), les premier et deuxième signaux d'horloge ayant une même première période, et à partir d'un troisième signal périodique (Osc) ayant une deuxième période égale à ladite première période divisée par un nombre (K) supérieur ou égal à deux, ledit procédé comprenant les étapes successives suivantes :
- compter un nombre (Cnt) de périodes complètes dudit troisième signal réalisées pendant une période complète dudit deuxième signal d'horloge (Clk) ; et
- générer ledit premier signal d'horloge (S_Clk) en déphasant ledit deuxième signal d'horloge (Clk) d'un retard (D) égal à ladite deuxième période multipliée par un autre nombre compris entre zéro et ledit nombre (Cnt).

**Fig. 2**

**EP 4 604 444 A1**

**Description**

Domaine technique

La présente description concerne de façon générale les circuits et dispositifs électroniques, et les communications pouvant être mises en oeuvre entre des circuits et dispositifs électroniques. La présente description se rapporte plus précisément à la gestion d'une communication entre des dispositifs électroniques utilisant plusieurs canaux de communication synchronisés par un même signal d'horloge. La présente description concerne la gestion d'un tel signal d'horloge.

Technique antérieure

Il existe différents moyens permettant de transmettre des données entre des dispositifs électroniques. Des données peuvent être transmises "en série" sur un même canal de communication, c'est-à-dire les unes à la suite des autres. Lorsqu'un grand nombre de données sont à transmettre, il est commun d'utiliser des procédés sérialiseur/désérialiseur, qui sont couteux en énergie, et peuvent présenter des problèmes de performance.

Une autre technique permettant de transférer un grand nombre de données entre des dispositifs, est d'utiliser plusieurs canaux de communication pour transmettre des données "en parallèle", c'est-à-dire toutes en même temps sur des entrées et sorties différentes. Pour différencier des données transmises en parallèle, il est important d'assurer leurs synchronisations avec un ou plusieurs signaux d'horloge différents.

Il serait souhaitable de pouvoir améliorer, au moins en partie, certains aspects de la gestion d'un signal d'horloge dans une communication entre des dispositifs électroniques.

Résumé de l'invention

Il existe un besoin pour des communications de données en parallèle plus performante.

Il existe un besoin pour des communications de données en parallèle dans lesquelles les données sont mieux synchronisées entre elles.

Il existe un besoin pour des communications de données en parallèle dans lesquelles un nouveau signal d'horloge est généré pour la réception des données.

Un mode de réalisation pallie tout ou partie des inconvénients des communications connues de données en parallèle.

Un mode de réalisation pallie tout ou partie des inconvénients des gestions de signaux d'horloge connus dans des communications de données en parallèle.

Un mode de réalisation prévoit l'utilisation d'un procédé de génération d'un signal d'horloge de réception de données déphasé par rapport à un signal d'horloge transmis avec les données.

Un mode de réalisation prévoit l'utilisation d'un circuit de génération d'un signal d'horloge de réception de données déphasé par rapport à un signal d'horloge transmis avec les données.

Un mode de réalisation prévoit un procédé de génération d'un premier signal d'horloge à partir d'un deuxième signal d'horloge, les premier et deuxième signaux d'horloge ayant une même première période temporelle, et à partir d'un troisième signal périodique ayant une deuxième période temporelle égale à ladite première période temporelle divisée par un premier nombre supérieur ou égal à deux, ledit procédé comprenant les étapes successives suivantes :

- compter un deuxième nombre de périodes complètes dudit troisième signal réalisées pendant une période complète dudit deuxième signal d'horloge ; et
- générer ledit premier signal d'horloge en déphasant ledit deuxième signal d'horloge d'un retard égal à ladite deuxième période temporelle multipliée par un troisième nombre compris entre zéro et ledit deuxième nombre.

Un autre mode de réalisation prévoit un circuit de génération d'un premier signal d'horloge à partir d'un deuxième signal d'horloge, les premier et deuxième signaux d'horloge ayant une même première période temporelle, ledit circuit comprenant :

- un circuit oscillant adapté à générer un troisième signal ayant une deuxième période temporelle égale à ladite première période temporelle divisée par un premier nombre supérieur ou égal à deux ;
- un compteur adapté à compter un deuxième nombre de périodes complètes dudit troisième signal réalisées pendant une période complète dudit deuxième signal d'horloge ; et
- un circuit retardateur adapté à générer ledit premier signal d'horloge en déphasant ledit deuxième signal d'horloge d'un retard égal à ladite deuxième période temporelle multipliée par un troisième nombre compris entre zéro et ledit deuxième nombre.

Selon un mode de réalisation, ledit premier nombre est supérieur ou égal à quatre.

Selon un mode de réalisation, ledit premier nombre est supérieur ou égal à huit.

Selon un mode de réalisation, ledit troisième nombre est égal audit deuxième nombre divisé par un multiple de deux.

Selon un mode de réalisation, ledit troisième nombre est égal audit deuxième nombre divisé par un multiple de quatre.

Selon un mode de réalisation, le compte dudit deuxième nombre est réalisé en faisant une moyenne du nombre de périodes complètes dudit troisième signal qui sont réalisées pendant plusieurs périodes complètes dudit deuxième signal d'horloge.

Selon un mode de réalisation, pour déphaser ledit deuxième signal d'horloge, sont utilisés un quatrième signal changeant d'état à chaque front montant dudit deuxième signal d'horloge et étant retardé dudit retard, et un cinquième signal changeant d'état à chaque front descendant dudit deuxième signal d'horloge et étant retardé dudit retard.

Selon un mode de réalisation, pour obtenir ledit premier signal, une porte logique de type "OU EXCLUSIF" est appliquée audit quatrième signal et audit cinquième signal.

Selon un mode de réalisation, la génération dudit premier signal d'horloge est mise en oeuvre par un circuit retardateur prenant en entrée ledit troisième nombre.

Un autre mode de réalisation prévoit un dispositif électronique comprenant un circuit décrit précédemment.

Selon un mode de réalisation, ledit circuit est compris dans un module de communication dudit dispositif.

Un autre mode de réalisation prévoit un procédé de communication entre un premier dispositif électronique décrit précédemment et un second dispositif électronique.

Selon un mode de réalisation, ledit premier signal d'horloge est utilisé pour synchroniser des signaux de données reçus par ledit premier dispositif.

Selon un mode de réalisation, le procédé de communication utilise le protocole single data rate, le protocole double data rate, ou le protocole quad data rate.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, très schématiquement et sous forme de blocs, un exemple de système pouvant mettre en oeuvre les modes de réalisation décrits ci-après ;

la figure 2 représente, très schématiquement et sous forme de blocs, un mode de réalisation d'un circuit de génération d'un signal d'horloge ;

la figure 3 représente un organigramme illustrant un mode de mise en oeuvre d'un procédé de génération d'un signal d'horloge ;

la figure 4 représente un exemple pratique du mode de réalisation de la figure 2 ;

la figure 5 représente des chronogrammes illustrant le fonctionnement du circuit de la figure 4 ; et

la figure 6 représente un autre exemple pratique d'une partie du mode de réalisation de la figure 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

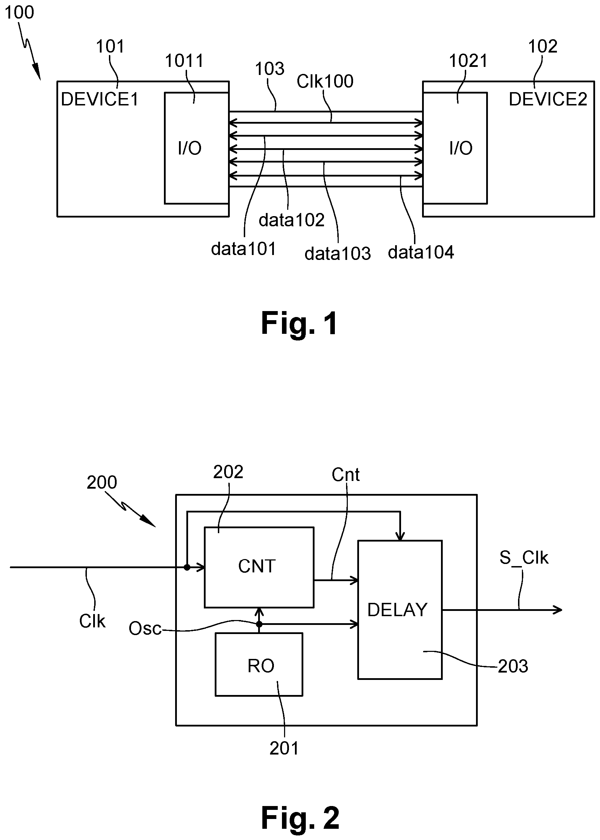

Les modes de réalisation décrits ci-après concernent la gestion d'un signal d'horloge, par exemple, pendant la mise en oeuvre d'une communication de données entre plusieurs dispositifs, et, plus particulièrement, la synchronisation de données sur un signal d'horloge à réception de ces données par un dispositif électronique. Pour cela, ces modes de réalisation prévoient la génération d'un signal d'horloge de réception de données décalé par rapport à un signal d'horloge transmis avec lesdites données. Cette génération est décrite en détails en relation avec les figures 2 à 5.

De plus, les modes de réalisation décrits ci-après sont tout particulièrement adaptés à des systèmes électroniques utilisant des communications de données en parallèle, c'est-à-dire des communications comprenant plusieurs canaux de communication transmettant des données différentes. Ces systèmes sont, par exemple, des puces électroniques comprenant plusieurs composants électroniques communiquant entre eux via de telles communications, comme des circuits intégrés à application spécifique (ASIC, Application-specific integrated circuit). Ces puces sont par exemple destinées à des systèmes électroniques complexes, tels que des systèmes électroniques utilisés dans des véhicules automobiles ou des engins extra-atmosphériques.

La figure 1 représente, très schématiquement et sous forme de blocs, un exemple d'un système électronique 100 adapté à mettre en oeuvre les modes de réalisation décrits plus en détails en relation avec les figures 2 à 5.

Le système électronique 100 comprend au moins deux dispositifs électroniques 101 (DEVICE 1) et 102 (DEVICE 2) adaptés à communiquer entre eux en utilisant un dispositif de communication 103. Chaque dispositif 101, respectivement 102 comprend au moins un module de communication 1011 (I/O), respectivement 1021 (I/O), leur permettant de mettre en oeuvre le dispositif de communication 103.

Selon un mode de réalisation, le dispositif de communication 103 permet de transférer des données entre les dispositif 101 et 102 en utilisant au moins deux canaux de communication. Plus particulièrement, le dispositif 103 comprend au moins deux canaux de communication, parmi lesquels :

- un premier canal Clk100 adapté à transmettre un signal d'horloge, appelé canal d'horloge ci-après ; et
- un ou plusieurs, de préférence plusieurs, canaux data101, data102, data103, data104, adaptés à transmettre des données, appelé canaux de transmission de données ci-après.

On appelle ici et dans toute cette description "signal d'horloge", un signal numérique périodique de type créneau. Un signal d'horloge est qualifié par sa fréquence et sa période, aussi appelée cycle d'horloge. Son amplitude varie entre un niveau bas, correspondant généralement à un niveau "zéro" ou niveau nul, et un niveau haut, correspondant généralement à un niveau "un".

Le signal d'horloge transmis par le canal Clk100 est utilisé pour synchroniser, ou cadencer, les signaux de données transmis par le ou les canaux de transmission de données data101 à data104.

On appelle ici et dans toute cette description "signal de données", un signal numérique présentant des créneaux transmettant des données, et étant synchronisé sur un signal d'horloge. Son amplitude varie entre un niveau bas, correspondant généralement à un niveau "zéro" ou niveau nul, et un niveau haut, correspondant généralement à un niveau "un". La valeur de l'amplitude d'un signal de données, pendant un cycle d'horloge, représente la valeur d'un bit de donnée.

Dans l'exemple illustré en figure 1, le dispositif 103 comprend quatre canaux de transmission de données data101, data102, data103, data104.

Il est à noter qu'un dispositif du type des dispositifs 101 peut également envoyer des groupes de signaux de données, chaque groupe utilisant son propre signal d'horloge. Les modes de réalisation décrits ci-après peuvent être adaptés à un tel fonctionnement.

Un problème pouvant apparaître dans un système du type du système 100, est que des signaux de données reçus par un dispositif peuvent ne plus être synchronisés de manière fiable avec le signal d'horloge transmis par le canal d'horloge. Les modes de réalisation décrits ci-après se proposent de générer un signal d'horloge de réception sur lequel il est certain que les signaux de données sont correctement synchronisés.

La figure 2 représente, très schématiquement et sous forme de bloc, un mode de réalisation d'un circuit 200 de génération d'un signal d'horloge de réception de données.

Selon un mode de réalisation, le circuit 200 est adapté à recevoir un signal d'horloge de transmission de données Clk, c'est-à-dire un signal d'horloge transmis avec des données, par exemple transmis avec un canal d'horloge du type du canal Clk100 décrit en relation avec la figure 1. Le signal d'horloge Clk est utilisé pour synchroniser des signaux de données. Le signal d'horloge Clk a une fréquence d'horloge Fclk et une période Tclk.

Le circuit 200 est, en outre, adapté à fournir un signal d'horloge de réception de données S_Clk qui est un signal d'horloge avec lesquels des signaux de données associés au signal d'horloge Clk sont synchronisés. Selon un mode de réalisation, le signal d'horloge de réception de données S_Clk a la même fréquence d'horloge Fclk que le signal d'horloge Clk. Selon un exemple, le signal d'horloge Clk a une fréquence comprise entre 50 MHz et 10 GHz, de préférence 500 MHz et 2 GHz.

Selon une variante de réalisation à la portée de la personne du métier, le signal d'horloge de réception de données S_Clk a une fréquence différente de la fréquence Fclk. Plus particulièrement, le signal S_Clk a une fréquence égale à un multiple de la fréquence Fclk, comme de préférence, une fréquence égale au double ou à la moitié de la fréquence Fclk.

Selon un mode de réalisation, le circuit 200 peut faire partie d'un module de communication, du type du module de communication 1011 ou 1021 décrit en relation avec la figure 1, d'un système du type du système 100 de la figure 1.

Le circuit 200 comprend un circuit oscillant 201 (RO) adapté à générer un signal Osc de manière indépendante du signal d'horloge Clk. Le signal Osc est un signal numérique périodique de type créneau. Le signal d'horloge Osc a une fréquence Fosc et une période Tosc. Selon un mode de réalisation, la fréquence Fosc est supérieure à la fréquence d'horloge Fclk. De même, selon un mode de réalisation, la période Tosc est inférieure au cycle d'horloge Tclk.

Plus particulièrement, la période Tosc est donnée par la formule mathématique suivante :

[Math 1]

$$Tosc \geq \frac{Tclk}{K}$$

dans laquelle K est un nombre positif supérieur ou égal à deux, de préférence supérieur ou égal à quatre, et encore plus préférentiellement supérieur ou égal à huit.

Selon un mode de réalisation préféré, K est un entier naturel supérieur ou égal à deux. Lorsque le nombre K n'est pas un entier, le circuit 200 fonctionne avec une gigue, que l'on peut compenser par un circuit de correction de gigue (jitter).

Le circuit 200 comprend, en outre, un compteur 202 (CNT) adapté à recevoir le signal d'horloge Clk et le signal Osc. Le compteur 202 est utilisé pour compter le nombre de périodes du signal Osc qui ont été effectuées complètement pendant un cycle d'horloge Tclk du signal d'horloge Clk. Pour cela, la valeur du compteur est mise à zéro en début d'un cycle d'horloge du signal d'horloge Clk, puis cette valeur est incrémentée à chaque fois qu'une période complète du signal Osc est effectuée. Le compteur 202 fournit, en sortie, sa valeur cnt.

Le circuit 200 comprend, en outre, un circuit retardateur 203 (DELAY) adapté à déphaser le signal d'horloge Clk d'un retard temporel D. Selon un mode de réalisation, le circuit retardateur 203 est adapté à recevoir le signal d'horloge Clk. Selon un exemple, le circuit retardateur 203 est adapté à recevoir, en outre, la valeur cnt et le signal Osc. Selon un mode de réalisation, le circuit retardateur 203 est adapté à fournir, en sortie, le signal d'horloge de réception S_Clk.

Selon un premier mode de réalisation, le retard temporel D appliqué par le circuit retardateur est donné par la formule mathématique suivante:

[Math 2]

$$D = Tosc * P$$

dans laquelle P est un paramètre défini par un utilisateur, de préférence, P est compris entre 1 et la valeur cnt.

Selon un deuxième mode de réalisation préféré, le retard temporel D appliqué par le circuit retardateur est donné par la formule mathématique suivante, qui définit plus en détail le paramètre P :

[Math 3]

$$D = Tosc * \frac{cnt}{2*n}$$

dans laquelle n est un nombre, de préférence un entier égal à :

- un si les signaux de données synchronisés sur le signal d'horloge Clk suivent un protocole de single data rate (SDR) ;
- deux si les signaux de données synchronisés sur le signal d'horloge Clk suivent un protocole de double data rate (DDR) ;
- quatre si les signaux de données synchronisés sur le signal d'horloge Clk suivent un protocole de quad data rate (QDR).

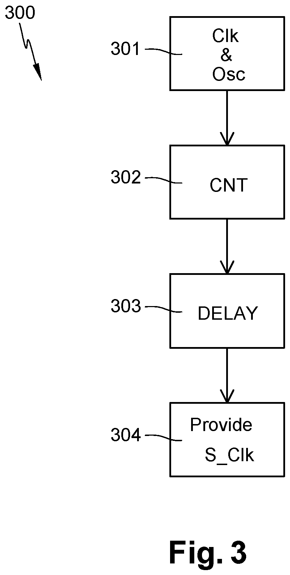

Le fonctionnement et les avantages que présentent le circuit 200 sont décrits en détail en relation avec la figure 3.

La figure 3 est un schéma-bloc illustrant la réalisation d'un mode de mise en oeuvre d'un procédé 300 de génération d'un signal d'horloge de réception de données. Plus particulièrement, la figure 3 illustre le fonctionnement du circuit 200 décrit en relation avec la figure 1.

A une étape initiale 301 (Clk & Osc), le circuit 200 reçoit le signal d'horloge Clk. Le circuit oscillant 201 du circuit 200 génère, ou commence à générer, le signal Osc.

A une étape 302 (CNT), successive à l'étape 301, une étape de comptage est mise en oeuvre par le compteur 202. Pour cela, la valeur cnt du compteur est mise à zéro au début d'un cycle d'horloge du signal d'horloge Clk, puis est incrémentée à chaque fois qu'une période complète du signal Osc s'achève. Selon un exemple, on considère qu'une période du signal d'horloge Clk ou du signal Osc commence à un front montant, et se termine au front montant suivant. Dans ce cas, la valeur cnt du compteur est mise à zéro à un premier front montant du signal d'horloge Clk, puis est incrémentée à chaque fois que le signal Osc présente deux fronts montant consécutifs. A titre de variante, on peut considérer qu'une période du signal d'horloge Clk ou du signal Osc commence à un front descendant, et se termine au front descendant suivant.

L'étape 302 se termine lorsque le cycle d'horloge du signal d'horloge Clk se termine. La valeur cnt du compteur 202 représente alors le nombre de périodes complètes du signal Osc s'étant produites pendant un cycle d'horloge du signal d'horloge Clk. La valeur cnt est prête à être fournie à d'autres circuits du dispositif 200.

Selon une variante de réalisation, la valeur cnt du compteur pourrait aussi être calculée en prenant une moyenne sur plusieurs cycle d'horloge du signal Clk, du nombre de périodes complètes du signal Osc s'étant produites. La valeur cnt pourrait, dans ce cas, ne pas être un entier. La valeur cnt peut, dans un premier mode de réalisation, être arrondie à l'entier supérieur, ou, dans un deuxième mode de réalisation, être arrondie à l'entier inférieur. C'est à l'utilisateur de choisir ce qui lui convient le mieux en fonction des protocoles de communication utilisés.

A une étape 303 (DELAY), successive à l'étape 302, un nouveau signal d'horloge S_Clk correspondant au signal d'horloge Clk retardé temporellement du retard D défini précédemment est généré par le circuit retardateur 203. Pour rappel, selon un premier mode de réalisation, le retard D dépend du paramètre P compris entre un et la valeur cnt, et selon un deuxième mode de réalisation préféré, le retard D dépend de la valeur cnt.

A une étape 304 (Provide S_Clk), successive à l'étape 303, le signal d'horloge Clk retardé du retard temporel D est égal au signal d'horloge de réception S_Clk. Le signal S_Clk est donc fourni en sortie par le circuit retardateur 203.

Un avantage de ce mode de réalisation est qu'il permet de fournir un signal d'horloge de réception de donnée mieux synchronisé avec des signaux de données reçus par un dispositif électronique. En effet, il peut arriver qu'un dispositif de transmission de données provoque, de manière non intentionnelle, une désynchronisation de signaux de données et du signal d'horloge qui leur est associé. Cela peut permettre d'échantillonner les signaux de données quand ils sont stables, car cela peut nécessiter un ajustement de la phase du signal d'horloge S_CLK. Cela peut aussi permettre de pallier certaines variabilités inhérentes aux procédés de fabrication des composants et des dispositifs électroniques.

Pour assurer la bonne synchronisation de signaux de données avec le signal d'horloge de réception, celui-ci est décalé d'un retard correspondant au moment du cycle d'horloge où une donnée représentée par un signal de donnée est la plus stable, c'est-à-dire le point équidistant entre la donnée d'un cycle et la donnée du cycle suivant. Ce moment diffère en fonction du protocole de communication utilisé. P protocoles sont possibles comme le single data rate, le double data rate, et le quad-data-rate.

Dans le cas de l'utilisation du protocole single data rate, un signal de donnée présente un bit de donnée pendant un cycle d'horloge. Le moment où la valeur du bit de donnée transmis par le signal est la plus stable est à la mi-période ou au milieu du cycle d'horloge. Il est donc intéressant de décaler le signal d'horloge de réception d'un retard temporel équivalent à environ une demi-période. Ce retard temporel est évalué sur la base du signal Osc comme décrit précédemment.

Dans le cas de l'utilisation du protocole double data rate, un signal de donnée présente deux bits de donnée pendant un cycle d'horloge, un premier bit pendant son état "haut" et un deuxième bit pendant son état "bas". Les moments où les valeurs de ces bits de donnée transmis par le signal sont les plus stables sont au premier quart de cycle d'horloge et au troisième quart du cycle d'horloge. Il est donc intéressant de décaler le signal d'horloge de réception d'un retard temporel équivalent à environ un quart de période. Ce retard temporel est évalué sur la base du signal Osc comme décrit précédemment.

Dans le cas de l'utilisation du protocole quad-data-rate, un signal de donnée présente quatre bits de donnée pendant un cycle d'horloge, un premier bit pendant la transition d'un état "bas" à un état "haut", un deuxième bit pendant son état "haut", un troisième bit pendant la transition d'un état "haut" à un état "bas" et un quatrième bit pendant l'état "bas". Les moments où les valeurs de ces bits de donnée transmis par le signal sont les plus stables sont au premier huitième de cycle d'horloge, au troisième huitième de cycle d'horloge, au cinquième huitième de cycle d'horloge, et au septième huitième du cycle d'horloge. Il est donc intéressant de décaler le signal d'horloge de réception d'un retard temporel équivalent à environ un huitième de période. Ce retard temporel est évalué sur la base du signal Osc comme décrit précédemment.

Selon un mode de réalisation, un tel procédé de génération d'un signal d'horloge de réception de données peut être compris dans un procédé de communication au sein d'un système du type du système 100 décrit en relation avec la figure 1.

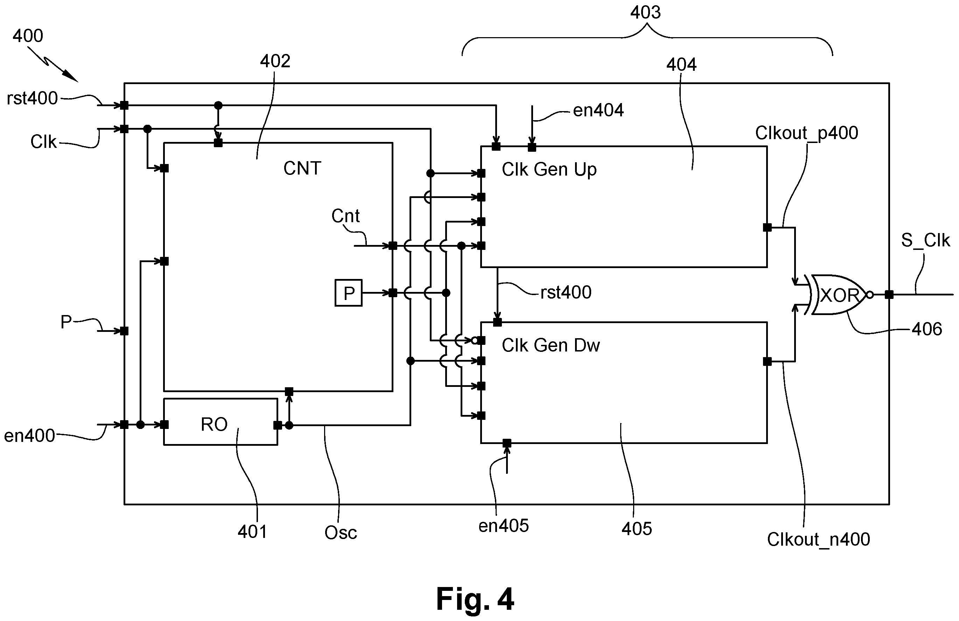

La figure 4 représente, sous forme de blocs, un exemple pratique d'un mode de réalisation d'un circuit 400 de génération d'un signal d'horloge de réception de données du type du circuit 200 décrit en relation avec la figure 1.

Selon un exemple, le circuit 400 reçoit :

- le signal d'horloge Clk ;
- un signal de réinitialisation rst400 ;
- un signal d'activation en400 ; et
- un signal représentant le paramètre P défini précédemment.

Selon un mode de réalisation, le circuit 400 fournit, en sortie, le signal d'horloge de réception S_Clk.

De plus, comme décrit précédemment, le circuit 400 comprend :

- un circuit oscillant 401 (RO) ;
- un compteur 402 (CNT) ; et
- un circuit retardateur 403.

Comme le circuit oscillant 201, le circuit oscillant 401 est adapté à générer le signal Osc, défini précédemment, de manière indépendante du signal d'horloge Clk. Selon un exemple, le circuit oscillant 401 est adapté à être démarré ou activé par le signal d'activation en400.

Comme le compteur 202, le compteur 402 est utilisé pour compter le nombre de périodes du signal Osc qui ont été effectuées complètement pendant un cycle d'horloge Tclk du signal d'horloge Clk. Pour cela, le compteur 402 reçoit le signal d'horloge Clk, le signal Osc, et le paramètre P. De plus, le compteur 402 est adapté à être démarré ou activé par le signal d'activation en400, et à être réinitialisé par le signal de réinitialisation rst400.

Comme le circuit retardateur 203, le circuit retardateur 403 est adapté à déphaser le signal d'horloge Clk d'un retard temporel D défini précédemment. Dans l'exemple illustré en figure 4, le circuit retardateur 403 comporte :

- un premier circuit de décalage de front montant 404 (Clk Gen Up) ;
- un deuxième circuit de décalage de front descendant 405 (Clk Gen DW) ; et
- une porte logique 406 (XOR) de type "OU EXCLUSIF", aussi appelé porte XOR.

Selon un premier mode de réalisation, le compteur 402 est adapté à transmettre le nombre de périodes du signal Osc qui ont été effectuées complètement pendant un cycle d'horloge Tclk et le paramètre P au circuit retardateur 403. Selon un deuxième mode de réalisation, le compteur 402 est adapté à transmettre directement le résultat de la décision entre le nombre de périodes du signal Osc qui ont été effectuées complètement pendant un cycle d'horloge Tclk et le paramètre P au circuit retardateur 403.

Selon un exemple, le premier circuit de décalage de front montant 404 est adapté à recevoir :

- le signal d'horloge Clk ;
- le signal de réinitialisation rst400 ;
- le signal Osc ;
- un signal d'activation en404 ;
- le signal représentant le paramètre P, le cas échéant ; et
- un signal représentant la valeur cnt, le cas échéant.

Le premier circuit 404 est adapté à fournir, en sortie, un premier signal décalé Clkout_p400. Le premier circuit 404 est démarré par le signal d'activation en404.

Le premier circuit 404 est adapté à décaler du retard temporel D les fronts montants du signal d'horloge Clk. Pour cela, le premier circuit 404 utilise le paramètre P et/ou la valeur cnt en combinaison avec le signal Osc pour déterminer le retard D. Plus particulièrement, à chaque front montant du signal d'horloge Clk, le premier circuit 404 attend le temps du retard temporel D pour modifier l'état de son signal de sortie Clkout_p400.

Selon un exemple, le deuxième circuit de décalage de front descendant 405 est adapté à recevoir :

- le signal d'horloge Clk ;
- le signal de réinitialisation rst400 ;
- le signal Osc ;

- un signal d'activation en404 ;
- le signal représentant le paramètre P, le cas échéant ; et
- un signal représentant la valeur cnt, le cas échéant.

Le deuxième circuit 405 est adapté à fournir, en sortie, un deuxième signal décalé Clkout_p400. Le deuxième circuit 405 est démarré par le signal d'activation en405.
Le deuxième circuit 405 est adapté à décaler du retard temporel D les fronts descendants du signal d'horloge Clk. Pour cela, le deuxième circuit 405 utilise le paramètre P et/ou la valeur cnt en combinaison avec le signal Osc pour déterminer le retard D. Plus particulièrement, à chaque front descendant du signal d'horloge Clk, le deuxième circuit 405 attend le temps du retard temporel D pour modifier l'état de son signal de sortie Clkout_n400.
La porte XOR 406 reçoit, en entrée, les deux signaux Clkout_p400 et Clkout_n400 et leur applique la fonction logique "OU EXCLUSIF" pour obtenir en sortie le signal d'horloge de réception S_Clk.

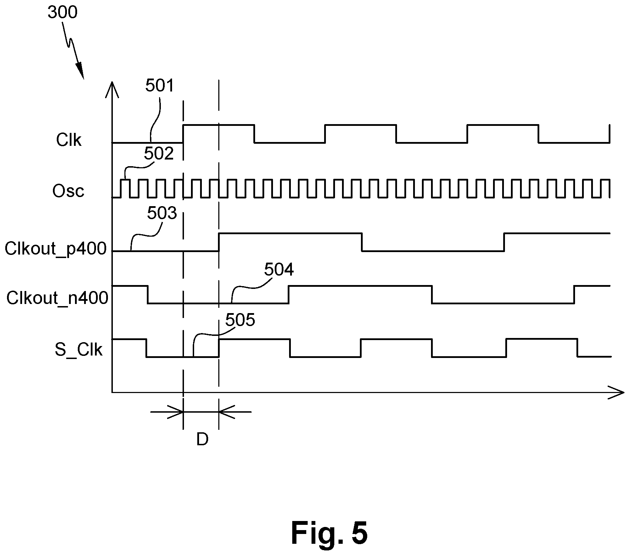

La figure 5 comprend des chronogrammes illustrant l'évolution temporelle de signaux du circuit 400 décrit en relation avec la figure 4.
Plus particulièrement, la figure 5 comprend :

- un chronogramme 501 illustrant l'évolution temporelle du signal d'horloge Clk ;
- un chronogramme 502 illustrant l'évolution temporelle du signal Osc ;
- un chronogramme 503 illustrant l'évolution temporelle du premier signal décalé Clkout_p400 ;
- un chronogramme 504 illustrant l'évolution temporelle du premier signal décalé Clkout_n400 ; et
- un chronogramme 505 illustrant l'évolution temporelle du signal d'horloge de réception S_Clk.

Comme décrit précédemment, le signal Osc a une période Tosc au moins inférieure au cycle d'horloge Tclk divisé par deux. Dans le cas illustré en figure 5, la période Tosc est égale à un huitième du cycle d'horloge Tclk.
Il est convenu que la valeur cnt déterminée par le compteur est de huit, et que le retard D est donné par la formule mathématique suivante :

[Math 4]

$$D = Tosc * \frac{8}{2 * 2} = 2 * \text{Tosc}$$

Comme décrit précédemment, le signal Clkout_p400 change d'état à chaque front montant du signal d'horloge Clk en étant retardé du retard D, et le signal Clkout_n400 change d'état à chaque front descendant du signal d'horloge Clk en étant retardé du retard D. Le signal S_Clk est bien égale à la combinaison par la porte logique XOR des signaux Clkout_p400 et Clkout_n400.

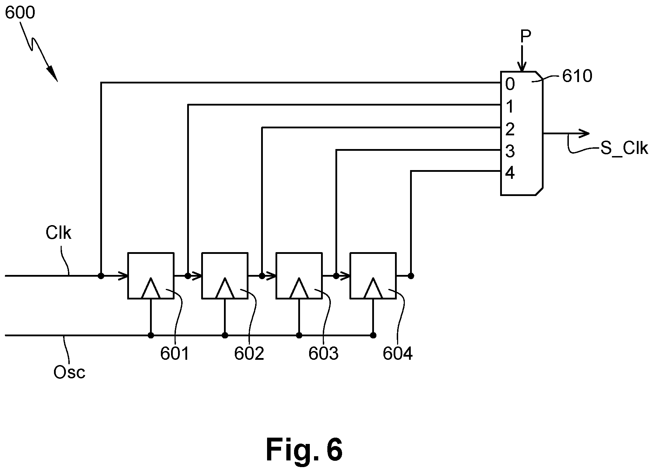

La figure 6 représente un autre exemple de réalisation d'un circuit retardateur 600 pouvant être utilisé comme le circuit retardateur 203 décrit en relation avec la figure 2.
Comme le circuit retardateur 203, le circuit retardateur 600 est adapté à recevoir, en entrée, le signal d'horloge Clk et le signal périodique Osc, et à fournir, en sortie, le nouveau signal d'horloge S_Clk. Le circuit 600 est, en outre, adapté à recevoir, en entrée, le paramètre P décrit en relation avec la figure 2.
Le circuit retardateur 600 comprend des bascules 601 à 604 et un sélecteur 610. Le circuit retardateur 600 est adapté à fournir un signal S_Clk retardé de zéro (0) à quatre (4) périodes Tosc du signal Osc, en fonction de la valeur du paramètre P. Il est à la portée de la personne du métier d'adapter le circuit 600 pour retarder d'un nombre différent de période Tosc.
Les bascules 601 à 604 sont toutes commandées par le signal Osc. L'entrée de la bascule 601 est adaptée à recevoir le signal d'horloge. Les bascules 601 à 604 sont reliées en série. Autrement dit :

- la sortie de la bascule 601 est reliée, de préférence connectée, à l'entrée de la bascule 602 ;
- la sortie de la bascule 602 est reliée, de préférence connectée, à l'entrée de la bascule 603 ; et
- la sortie de la bascule 603 est reliée, de préférence connectée, à l'entrée de la bascule 604.

Le sélecteur 610 est adapté à choisir, en fonction du paramètre P, parmi le signal d'horloge Clk et les sorties des bascules 601 à 604. Ainsi pour cela, le sélecteur comprend cinq entrées 0 à 4 et une sortie fournissant le signal S_Clk. Plus particulièrement :

- l'entrée 0 est adaptée à recevoir le signal d'horloge Clk ;
- l'entrée 1 est reliée, de préférence connectée, à la sortie de la bascule 601 ;

- l'entrée 2 est reliée, de préférence connectée, à la sortie de la bascule 602 ;
- l'entrée 3 est reliée, de préférence connectée, à la sortie de la bascule 603 ; et
- l'entrée 4 est reliée, de préférence connectée, à la sortie de la bascule 604.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de génération (300) d'un premier signal d'horloge (S_Clk) à partir d'un deuxième signal d'horloge (Clk), les premier et deuxième signaux d'horloge (S_Clk, Clk) ayant une même première période temporelle (Tclk), et à partir d'un troisième signal périodique (Osc) ayant une deuxième période temporelle (Tosc) égale à ladite première période temporelle (Tclk) divisée par un premier nombre (K) supérieur ou égal à deux, ledit procédé comprenant les étapes successives suivantes :

   - compter un deuxième nombre (Cnt) de périodes complètes dudit troisième signal réalisées pendant une période complète dudit deuxième signal d'horloge (Clk) ; et
   - générer ledit premier signal d'horloge (S_Clk) en déphasant ledit deuxième signal d'horloge (Clk) d'un retard (D) égal à ladite deuxième période temporelle (Tosc) multipliée par un troisième nombre (P) compris entre zéro et ledit deuxième nombre (Cnt).

2. Circuit (200 ; 400) de génération d'un premier signal d'horloge (S_Clk) à partir d'un deuxième signal d'horloge (Clk), les premier et deuxième signaux d'horloge (S_Clk, Clk) ayant une même première période temporelle (Tclk), ledit circuit comprenant :

   - un circuit oscillant (201 ; 401) adapté à générer un troisième signal (Osc) ayant une deuxième période temporelle (Tosc) égale à ladite première période temporelle (Tclk) divisée par un premier nombre (K) supérieur ou égal à deux ;
   - un compteur (202 ; 302) adapté à compter un deuxième nombre (Cnt) de périodes complètes dudit troisième signal (Osc) réalisées pendant une période complète dudit deuxième signal d'horloge (Clk) ; et
   - un circuit retardateur (203 ; 403) adapté à générer ledit premier signal d'horloge en déphasant ledit deuxième signal d'horloge d'un retard (D) égal à ladite deuxième période temporelle multipliée par un troisième nombre (P) compris entre zéro et ledit deuxième nombre (Cnt).

3. Procédé selon la revendication 1, ou circuit selon la revendication 2, dans lequel ledit premier nombre (K) est supérieur ou égal à quatre.

4. Procédé ou circuit selon la revendication 3, dans lequel ledit premier nombre (K) est supérieur ou égal à huit.

5. Procédé selon l'une quelconque des revendications 1, 3, ou 4, ou circuit selon l'une quelconque des revendications 2 à 4, dans lequel ledit troisième nombre (P) est égal audit deuxième nombre (cnt) divisé par un multiple de deux.

6. Procédé ou circuit selon la revendication 5, dans lequel ledit troisième nombre (P) est égal audit deuxième nombre (cnt) divisé par un multiple de quatre.

7. Procédé selon l'une quelconque des revendications 1, 3 à 6, ou circuit selon l'une quelconque des revendications 2 à 6, dans lequel le compte dudit deuxième nombre (cnt) est réalisé en faisant une moyenne du nombre de périodes complètes dudit troisième signal (Osc) qui sont réalisées pendant plusieurs périodes complètes dudit deuxième signal d'horloge (Clk).

8. Procédé selon l'une quelconque des revendications 1, 3 à 7, ou circuit selon l'une quelconque des revendications 2 à 7, dans lequel, pour déphaser ledit deuxième signal d'horloge (Clk), sont utilisés un quatrième signal (Clkout_p400) changeant d'état à chaque front montant dudit deuxième signal d'horloge (Clk) et étant retardé dudit retard (D), et un cinquième signal (Clkout_n400) changeant d'état à chaque front descendant dudit deuxième signal d'horloge (Clk) et étant retardé dudit retard (D).

9. Procédé ou circuit selon la revendication 8, dans lequel, pour obtenir ledit premier signal (S_Clk), une porte logique de type "OU EXCLUSIF" est appliquée audit quatrième signal (Clkout_p400) et audit cinquième signal (Clkout_n400).

10. Procédé selon l'une quelconque des revendications 1, 3 à 7, ou circuit selon l'une quelconque des revendications 2 à 7, dans lequel la génération dudit premier signal d'horloge (S_Clk) est mise en oeuvre par un circuit retardateur (403) prenant en entrée ledit troisième nombre (P).

11. Dispositif électronique (101, 102) comprenant un circuit (200, 400) selon l'une quelconque des revendications 2 à 10.

12. Dispositif selon la revendication 11, dans lequel ledit circuit (200, 400) est compris dans un module de communication (1011, 1021) dudit dispositif (101, 102).

13. Procédé de communication entre un premier dispositif électronique (101, 102) selon la revendication 11 ou 12 et un second dispositif électronique (102, 101).

14. Procédé selon la revendication 13, dans lequel ledit premier signal d'horloge (S_Clk) est utilisé pour synchroniser des signaux de données (Data101, data102, data103, data104) reçus par ledit premier dispositif (101, 102).

15. Procédé selon la revendication 13 ou 14, dans lequel le procédé de communication utilise le protocole single data rate (SDR), le protocole double data rate (DDR), ou le protocole quad data rate (QDR).

100

101      1011              103    Clk100              1021        102

DEVICE1    I/O                                        I/O    DEVICE2

data102

data101      data103    data104

# Fig. 1

200        202              Cnt

Clk

Osc

CNT

RO

DELAY

S_Clk

203

201

# Fig. 2

300

301 — | Clk & Osc |

302 — | CNT |

303 — | DELAY |

304 — | Provide S_Clk |

# Fig. 3

**Fig. 4**

EP 4 604 444 A1

Fig. 5

Fig. 6

**RAPPORT DE RECHERCHE EUROPEENNE**

Europäisches Patentamt
European Patent Office
Office européen des brevets

Numéro de la demande

EP 25 15 5945

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2007/109880 A1 (ZHANG FULONG [US] ET AL) 17 mai 2007 (2007-05-17) * abrégé * * alinéa [0001] - alinéa [0044]; figures 1-7 * | 1-7, 10-15 | INV. H04L7/033 G06F1/04 G11C7/22 |
| | ----- | | |
| A | US 2004/140919 A1 (SCHAFFERER BERND [US]) 22 juillet 2004 (2004-07-22) * abrégé * * alinéa [0006] - alinéa [0012] * * alinéa [0027] - alinéa [0045]; figures 1-8 * | 8,9 | |
| | ----- | | |
| A | US 7 893 739 B1 (NAGARAJAN PRADEEP [US] ET AL) 22 février 2011 (2011-02-22) * colonne 2, ligne 54 - ligne 57 * | 15 | |
| | ----- | | |

**DOMAINES TECHNIQUES RECHERCHES (IPC)**

H04L
G06F
G11C

Le présent rapport a été établi pour toutes les revendications

| Lieu de la recherche | Date d'achèvement de la recherche | Examinateur |
|---|---|---|
| Berlin | 7 juillet 2025 | Leineweber, Hubert |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
....................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 15 5945

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-07-2025

| Document brevet cité au rapport de recherche | Date de publication | Membre(s) de la famille de brevet(s) | Date de publication |
|---|---|---|---|
| US 2007109880 A1 | 17-05-2007 | US 2007109880 A1<br>WO 2007059466 A2 | 17-05-2007<br>24-05-2007 |
| US 2004140919 A1 | 22-07-2004 | AUCUN | |
| US 7893739 B1 | 22-02-2011 | US 7893739 B1<br>US 8159277 B1 | 22-02-2011<br>17-04-2012 |

EPO FORM P0460

Pour tout renseignement concernant cette annexe : voir Journal Officiel de l'Office européen des brevets, No.12/82